# EUROPÄISCHE PATENTSCHRIFT

(11) **EP 1 867 375 B1**
(45) Veröffentlichungstag und Bekanntmachung des Hinweises auf die Patenterteilung: **10.03.2010**
(21) Anmeldenummer: 06021557.1
(22) Anmeldetag: 13.10.2006
(51) Int. Cl.: B01D 46/10, H05K 7/20, H02B 1/56

(54) **Filterlüfter mit einer Schnellbefestigungseinrichtung**
Filter fan with rapid fastening device
Ventilateur à filtre comprenant un dispositif de fixation rapide

(30) Priorität: 13.06.2006 DE 202006009355 U
(43) Veröffentlichungstag der Anmeldung: 19.12.2007
(73) Patentinhaber: Pfannenberg GmbH, 21035 Hamburg (DE)
(72) Erfinder: Pfannenberg, Andreas, 21035 Hamburg (DE)
(74) Vertreter: Richter, Werdermann, Gerbaulet & Hofmann

(56) Entgegenhaltungen:
- EP-A- 1 720 395
- DE-C1- 19 536 928
- DE-U1- 9 306 032
- US-A- 6 099 611

## Beschreibung

Die Erfindung betrifft einen Filterlüfter gemäß dem Oberbegriff des Anspruchs 1.

Zur Belüftung von Schaltschränken, elektronischen Steuereinrichtungen und Computern dienen Filterlüfter, die in eine korrespondierende Öffnung in einer Gehäusewand beispielsweise eines Schaltschranks eingesetzt sind. Die Filterlüfter verfügen über ein Gebläse, um Umgebungsluft in das Gehäuse hineinzufördern, wobei das Gehäuse zusätzlich mit Luftaustrittsschlitzen versehen ist. Um eine Verunreinigung der elektronischen Einrichtungen im Gehäuse zu vermeiden, verfügt der Filterlüfter über eine Filtereinrichtung, beispielsweise in Form einer austauschbaren Filtermatte.

Ein derartiger Filterlüfter ist aus der EP 0 439 667 B1 bekannt, wobei der Filterlüfter über ein Grundgehäuse mit einem Rahmen verfügt. An dem Rahmen sind Schnellbefestigungseinrichtungen in Form von federelastischen Laschen ausgebildet, um den Filterlüfter ohne zusätzliche Schrauben oder sonstige Montagemittel werkzeuglos in eine Gehäuseöffnung einsetzen und dort mit Hilfe der federelastischen Laschen verrasten zu können.

Als nachteilig hierbei ist es jedoch anzusehen, dass die federelastischen Laschen aus den Seitenwänden bzw. dem Rahmen des Grundgehäuses des Filterlüfters ausgeschnitten sind, so dass während des Betriebs des Filterlüfters durch diese seitlichen Öffnungen ungefilterte Luft in das Innere des Gehäuses, beispielsweise eines Computers, hineingesaugt werden kann.

Ähnliche Filterlüfter sind in der DE 93 06 032 U1 sowie der US 6,099,611 A offenbart. Die dort gezeigten Filtertüfter weisen ebenfalls Schnellbefestigungen in Form von federelastischen Laschen zur Befestigung des Filterlüfters in einem Ausschnitt einer Montagewand oder dergleichen auf. Jedoch sind auch hier die federlelastischen Laschen aus dem Wandmaterial des Rahmens des Grundgehäuses herausgebildet, indem der Rahmen an diesen Stellen durchbrochen wird. Im unbelasteten bzw. nicht voll belasteten Zustand stehen die federelastischen Laschen somit aus der Wandebene des Rahmens hervor, so dass sich ein Durchlass bzw. Durchbruch durch den Rahmen ins Innere des Filterlüfters ergibt, durch den ungefilterte Luft, Flüssigkeit und dergleichen ins Innere des Filterlüfters gelangen können.

Die nachveröffentlichte EP 1 720 395 A1 offenbart einen Filterlüfter mit einem Gehäuse, an dessen Seitenwänden hakenartigen Rastnasen angeordnet sind, die als Schnellbefestigungseinrichtung zur Befestigung des Filterlüfters in einem Ausschnitt einer Montagewand dienen.

Die DE 195 36 928 C1 offenbart ebenfalls einen Filterlüfter, an dessen Gehäuserahmen laschenartige, federelastische Befestigungselemente vorgesehen sind. Diese Befestigungselemente dienen allerdings zur Befestigung des Lüfters am Gehäuserahmen und nicht zur Befestigung des Lüfters an der Montagewand. Allerdings sind auch diese Befestigungselemente aus dem Wandmaterial des Gehäuses herausgeformt, so dass sich Durchbrüche ergeben, durch die Luft ins Gehäuseinnere strömen kann.

Der Erfindung liegt die Aufgabe zugrunde, einen Filterlüfter der eingangs genannten Art anzugeben, bei dem das Ansaugen von ungefilteter Luft vermieden wird.

Diese Aufgabe wird durch die im Anspruch 1 angegebenen Merkmale gelöst.

Bei einem derart erfindungsgemäß ausgebildeten Filterlüfter sind die Schnellbefestigungseinrichtungen in Form federelastischen Laschen nicht aus einem Abschnitt einer Seitenwand bzw. eines Rahmens des Grundgehäuses des Filterlüfters ausgeschnitten bzw. ausgeformt, sondern außenseitig an diesem Rahmen bzw. den Seitenwänden angeformt. Vorzugsweise besteht der Filterlüfter bzw. dessen Grundgehäuse aus einem Kunststoff-Spritzgussteil, so dass bei der Herstellung des Rahmens bereits die zusätzlichen Laschen einstückig mit dem Rahmen an diesem angeformt oder ausgebildet werden können. Die Laschen sind dabei quasi außenseitig am Rahmen angeordnet und weisen beispielsweise in einem Ausschnitt in einer Montagewand im montierten Zustand des Filterlüfters nach außen. Dadurch ist der Rahmen um den Umfang des Filterlüfters gesehen umlaufend durchgehend ausgebildet, beispielsweise als ein einziges Bauteil, und in den Seitenwänden des Rahmens sind keine Durchbrechungen bzw. Öffnungen vorhanden.

Es versteht sich, dass der Filterlüfter in an sich bekannter Weise zusätzlich mit einer Filtermatte und/oder einem Gebläse und/oder Luftleiteinrichtungen und dergleichen ausgestattet sein kann. Selbstverständlich können Lammellen, die als Luftleiteinrichtung dienen, auch schwenkbeweglich ausgebildet sein. Prinzipiell ist es möglich, dass an dem Rahmen lediglich eine einzige oder mehrere, bevorzugt wie im Folgenden beschrieben, federelastische Laschen angeordnet sind.

Der Vorteil der Erfindung besteht darin, dass durch das zusätzliche Anformen von federelastischen Laschen am Rahmen des Filterlüfters keine Öffnungen mehr in seitlichen Außenwänden vorhanden sind und der Rahmen im Wesentlichen durchgehend um den Umfang des Filterlüfters geschlossen ausgebildet ist. Somit ist das Eindringen von ungefilterter Luft, beispielsweise in ein Computergehäuse, wirkungsvoll vermieden. Ebenso kann kein Wasser durch die Seitenwände in das Innere des Filters eindringen und sich somit eine Filtermatte nicht mehr mit Feuchtigkeit voll saugen.

Ferner beträgt, besonders zur Montage am Computergehäuse, Schaltschränken, o. dgl., deren Gehäuse üblicherweise aus dünnwandigem Metall und/oder Kunststoff besteht, ein Zwischenraum zwischen einer oberen Kante einer Lasche und einer eine umlaufende Montagewandanlagekante bildenden Wandfläche zwischen 1 und 4 mm.

Die Formgebung des Filterlüfters ist dabei im Rahmen der Erfindung beliebig wählbar, bevorzugt wird der Filterlüfter jedoch eine rechteckige, kreisförmige oder ovale Gestalt aufweisen.

Im Vorhergehenden wurde der Filterlüfter im Wesentlichen im Zusammenhang mit Schaltschränken, elektronischen Steuereinrichtungen, Computern oder dergleichen beschrieben. Es ist jedoch ersichtlich, dass derartige Filterlüfter auch auf allen anderen Gebieten der Technik einsetzbar sind, beispielsweise als Filterlüfter, die in eine Bauwerksöffnung zur Belüftung eines Innenraums eines Gebäudes eingesetzt werden. In einem solchen Fall bietet sich die Ausbildung des Gehäuses des Filterlüfters aus Metall an.

Vorteilhafte Ausgestaltungen der Erfindung sind in den Unteransprüchen gekennzeichnet.

Zur Montage des Filterlüfters wird das Grundgehäuse in einen vorbereiteten Ausschnitt in der Montagewand eingeführt, wobei die Abmessungen des Ausschnitts in der Montagewand in etwa den Außenabmessungen des Rahmens des Grundgehäuses entsprechen. Beim Einsetzen des Grundgehäuses in den Ausschnitt in der Montagewand werden die federelastischen Laschen in Richtung des Rahmens beziehungsweise dessen Seitenwände niedergedrückt. Wenn der Rahmen mit seiner Montagewandanlagekante an der den Ausschnitt in der Montagewand begrenzenden Wandfläche zur Anlage gebracht ist federn die federelastischen Laschen in ihre Ausgangslage zurück und verriegeln quasi das Grundgehäuse an der Montagewand. Zum Lösen des Filterlüfters können die federelastischen Laschen mit einem geeigneten Werkzeug, beispielsweise ein Schraubendreher, niedergedrückt werden, um das Grundgehäuse aus dem Ausschnitt wieder herausziehen zu können. Mit dem vorstehend beschriebenen Zwischenraum kann der Filterlüfter beispielsweise an einem dünnwandigen Gehäuse eines Computers eingesetzt werden.

Zur Positionierung der federelastischen Laschen ist vorgeschlagen, dass diese an einer Ober- und/oder einer Unterseite eines quadratischen bzw. rechteckigen Filterlüfters jeweils an einem Eckbereich angeordnet sind. Somit kann der Filterlüfter beispielsweise nur mit zwei an der Ober- oder Unterkante oder mit vier an der Ober- und Unterkante angeordneten Laschen in einfacher Weise an einem Gehäuse befestigt werden. Prinzipiell können die Laschen auch an einer rechten und linken Seite des Filterlüfters angeordnet sein.

Weiterhin können die Laschen an einer rechten und/oder linken Seitenwand des Filterlüfters angeordnet sein, prinzipiell auch an allen vier Seitenwänden. Ist pro Seitenwand des Gehäuses jeweils nur eine Lasche vorgesehen, so ist diese vorzugsweise mittig angeordnet, um symmetrische Haltekräfte zu erzielen.

Zur verbesserten Abdichtung des in einem Ausschnitt der Montagewand eingesetzten Filterlüfters zu erhalten ist der Montagewandanlagekante ein Dichtungsmittel zugeordnet, um ein Eindringen von Luft und/oder Feuchtigkeit zwischen der Montagewandanlagekante und einer Gehäusewandung bzw. einer Montagewand zu unterbinden. Insbesondere ist das Dichtungsmittel in Form einer Gummidichtung aus einem hierfür geeigneten Material ausgebildet, die in eine um die Montagewandanlagekante durchgehend umlaufende Nut eingesetzt ist. Die Gummidichtung kann auch eingeklebt sein.

Zur Formgebung der Laschen ist vorgeschlagen, dass diese dreieckig oder rechteckig ausgebildet sind. Dabei kann die Formgebung, Dicke und Dimensionierung der Laschen vom Fachmann jeweils in Abhängigkeit der Anzahl und Positionierung der Laschen sowie der aufzubringenden Haltekräfte, d.h. im Wesentlichen in Abhängigkeit von Form und Größe des Filterlüfters, gewählt werden.

Zur Erhöhung der Belüftungsleistung können in einen entsprechen dimensionierten Ausschnitt der Montagewand mehrere Filterlüfter mit erfindungsgemäß ausgebildeten Laschen und Rahmen eingesetzt sein. Hierzu sind Verbindungselemente vorgesehen, die insbesondere mit den Laschen zweier benachbarter Filterlüfter jeweils in rastenden Eingriff bringbar sind, um somit eine lösbare Verbindung zwischen benachbarten Filterlüftern zu erhalten. Dabei kann das Verbindungselement in an sich beliebiger Weise ausgestaltet werden.

Ein Ausführungsbeispiel der Erfindung wird nachstehend anhand der Zeichnungen näher erläutert. Es zeigen:
- Fig. 1: einen Filterlüfter in einem senkrechten Schnitt,
- Fig. 2: eine Ansicht von vorn auf den Filterlüfter,
- Fig. 3: eine Rückansicht des Filterlüfters mit flügelartigen Laschen zur Schnellbefestigung des Filterlüfters an einer Montagewand,
- Fig. 4: eine Ansicht von oben auf den Rahmen des Filterlüfters mit den flügelartigen Laschen,
- Fig. 5: eine vergrößerte Ansicht eines Abschnittes des Rahmens des Filterlüfters mit einer flügelartigen Lasche,
- Fig. 6: eine weitere Ansicht von oben auf den Rahmen des Filterlüfters mit den flügelartigen Laschen,
- Fig. 7: einen Filterlüfter im Querschnitt, und
- Fig. 8: einen Filterlüfter in Draufsicht.

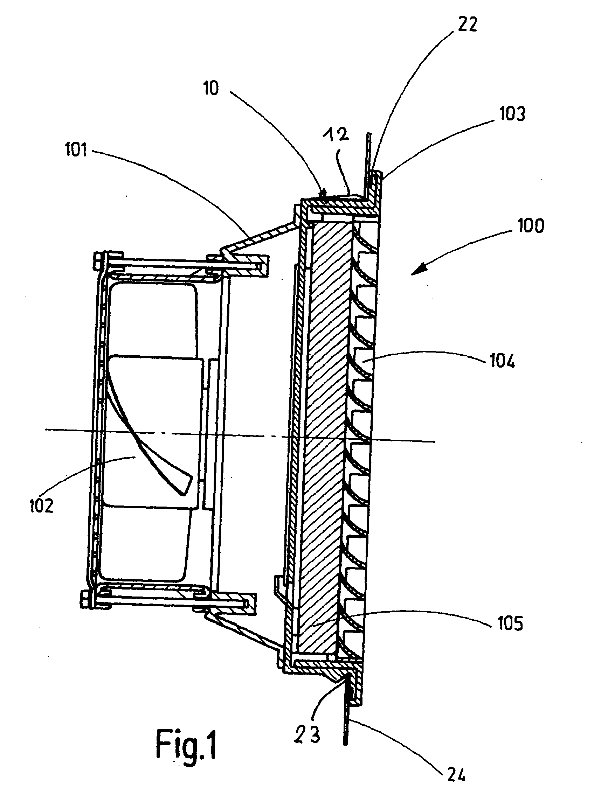

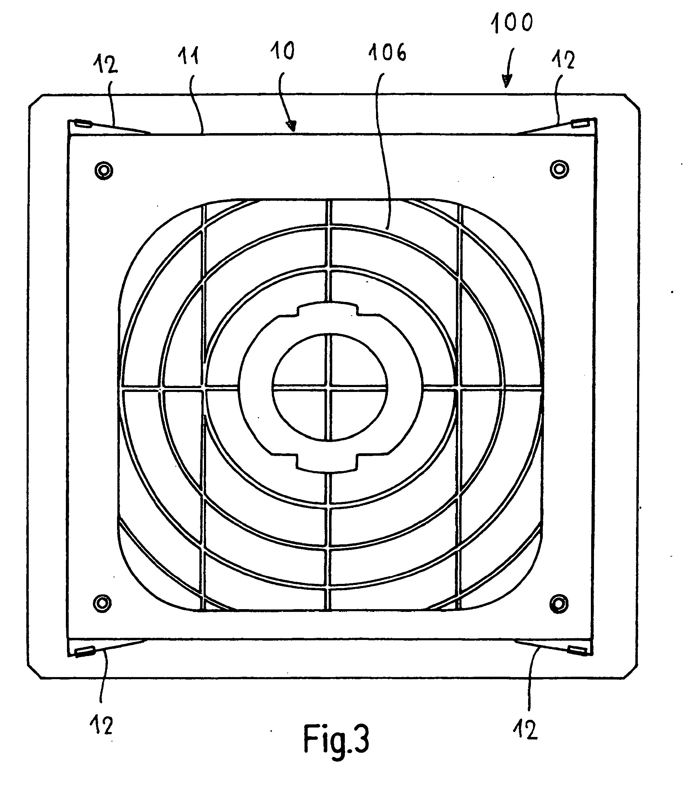

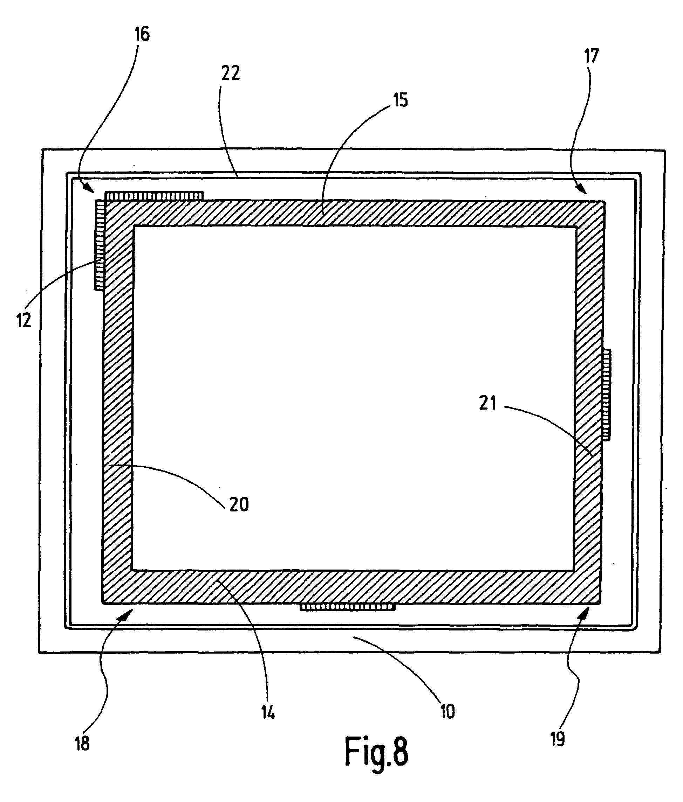

Der in den Fig. 1 bis 3 gezeigte Filterlüfter 100 besteht aus einem Grundgehäuse 10 mit einem Gebläseträger 101, der ein elektromotorisch betriebenes Gebläse 102 aufnimmt. Die offen ausgebildete Rückwand des Gebläseträgers 101 ist mittels eines Schutzgitters 106 verschlossen (Fig. 3). An das Grundgehäuse 10 ist vorzugsweise ein Rahmen 11 angeformt. Bei einem quadratischen oder rechteckigen Filterlüfter 100 besteht der Rahmen 11 aus vier Seitenwänden 14, 15, 20, 21 (Fig. 8).

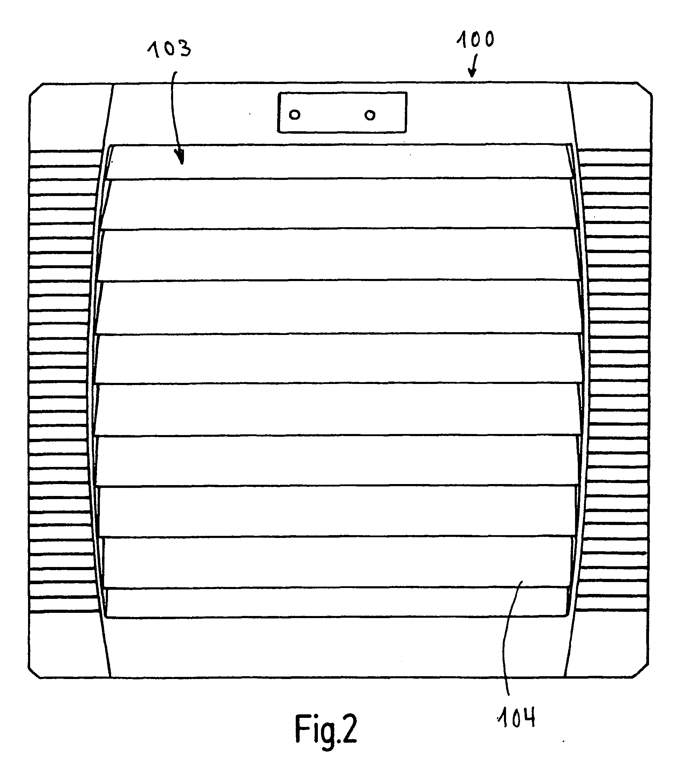

Das Grundgehäuse 10 weist vorderseitig einen Designträger 103 mit Luftleiteinrichtungen, beispielsweise in Form von Lamellen 104, auf (Fig. 1 und 2). Der Designträger 103 bzw. das Grundgehäuse 10 nimmt eine Filtermatte 105 zum Filtern der durch den Filterlüfter 100 geförderten Luft auf. Der Filterlüfter 100 ist aus einem oder mehreren Kunststoff-Spritzgussteilen und/oder aus Metallteilen aufgebaut. Der Designträger 103 ist über eine umlaufende Dichtung 22 mit dem Grundgehäuse 10 bevorzugterweise lösbar verbunden, um die Filtermatte 105 austauschen zu können (Fig. 1).

Der Filterlüfter 100 mit seinem Grundgehäuse 10 ist im eingebauten Zustand in einem Ausschnitt 23 in einer Montagewand 24, z. B. eines Schaltschrankes, angeordnet (Fig. 1).

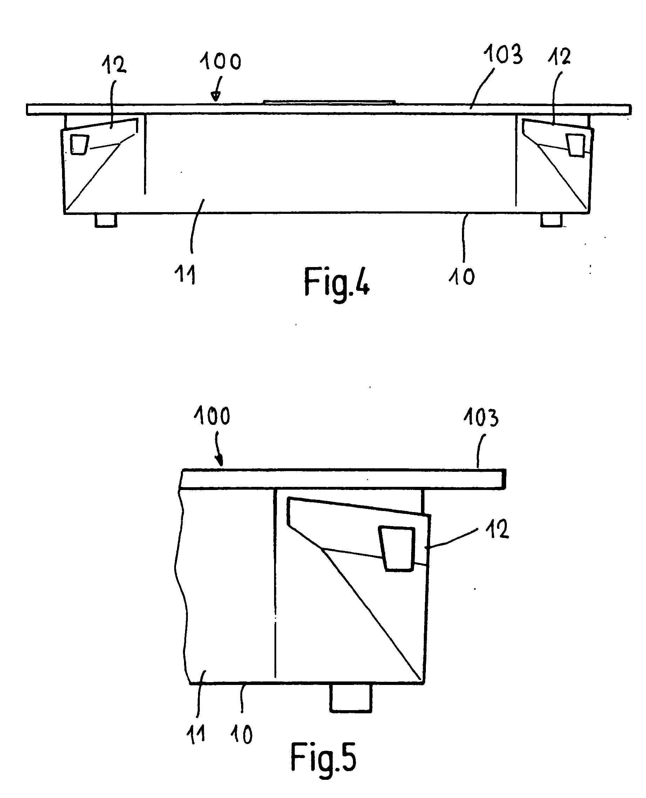

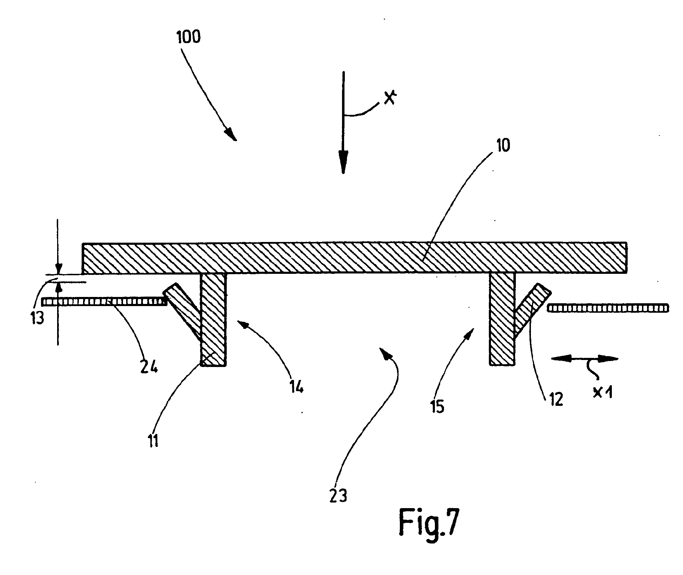

Zur lösbaren Befestigung des Filterlüfters 100 im Ausschnitt 23 der Montagewand 24 wird der Filterlüfter 100, wie durch den Pfeil X angegeben, in den Ausschnitt 23 eingeführt (Fig. 7). Dabei können die an dem Rahmen 11 angeformten, flügelartigen und federelastischen Laschen 12, wie durch den Doppelpfeil X1 verdeutlicht, geringfügig in Richtung zur Mitte des Ausschnitts 23 hin verbogen werden. Die Laschen 12 sind vorzugsweise einstückig mit den Seitenteilen 14, 15, 20, 21 des Rahmens 11 an diesen angeformt (Fig. 3, 4, 5, 6 und 7).

Sobald der Filterlüfter 100 weit genug in den Ausschnitt 23 eingeschoben ist federn die Laschen 12 in ihre Ausgangsposition zurück und verriegeln den Filterlüfter 100 in seiner eingesetzten Position. Zum Entfernen des Filterlüfters 100 können die Laschen 12 wieder leicht nach innen gedrückt werden.

Um den Filterlüfter 100 beispielsweise an einem Metall- oder Kunststoffgehäuse eines Computers, eines Schaltschranks o. dgl. zu befestigen, ist der Abstand beziehungsweise Zwischenraum 13 zwischen einer oberen Kante, einer Lasche 12 und einer Montagewandanlagekante des Grundgehäuses 10 vorzugsweise in einem Bereich zwischen ein und vier Millimeter gewählt.

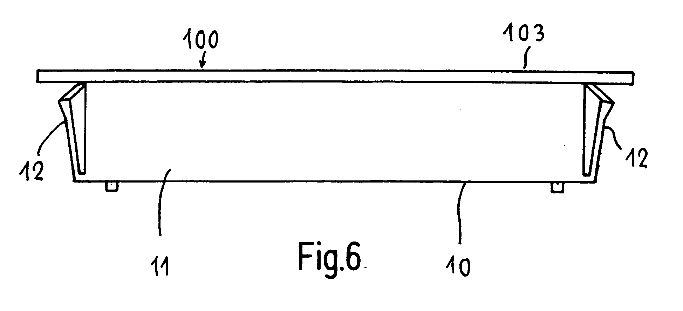

Dabei können die Laschen 12 entweder, wie in Fig. 8 am Rahmen 11 links oben dargestellt, jeweils benachbart an einem Eckbereich 16, 17, 18, 19 des Rahmens 11 angeordnet sein oder mittig an einer Seitenwand 14, 15, 20, 21, wie in Fig. 8 rechts unten ersichtlich. An dem Rahmen 11 können die Laschen 12 auch in sonstiger beliebiger Weise verteilt angeordnet sein. Die Laschen 12 können in an sich beliebiger weise ausgeformt sein, bevorzugt jedoch dreieckig oder rechteckig. Die Laschen 12 sind nicht aus dem Wandmaterial des Rahmens 11 herausgeformt, sondern angeformt (Fig. 6), so dass die Seitenwände 14, 15, 20, 21 des Rahmens 11 geschlossene Wandflächen bilden.

Die Anzahl der Laschen 12 kann beliebig gewählt sein, ebenso deren Anordnung am Rahmen 11. Neben einer Anordnung der Laschen 12 in den Eckbereichen 16, 17, 18, 19 können Laschen 12 auch in den mittigen Sei tenwandbereichen des Rahmens 11 vorgesehen sein. Mindestens zwei Laschen 12 sollten an sich gegenüberliegenden Seitenwänden des Rahmens 11 vorgesehen sein. Die Laschen 12 bestehen bevorzugterweise aus dem Material des Rahmens 11, jedoch weisen die Laschen eine federelastische Ausgestaltung auf, aufgrund der die Lasche 12 nach Aufhebung eines auf die Laschen ausgeübten Druckes zurückfedern können.

Um den Filterlüfter 100 im montierten Zustand, d.h. wenn die Montagewandanlagekante beziehungsweise das Grundgehäuse 10 im Wesentlichen bündig und flächig an der Montagewand 24 anliegt, abzudichten ist eine um den Filterlüfter 100 durchgehend umlaufende Gummidichtung 22 aus einem hierfür geeigneten Kunststoffmaterial vorgesehen. Insbesondere ist die Gummidichtung 22 in einer Nut eingeklebt, um das Eindringen von Luft und/oder Feuchtigkeit zwischen Filterlüfter 100 und Montagewand 24 zu vermeiden.

## Patentansprüche

1. Filterlüfter (100) mit einem Grundgehäuse (10) mit einem Rahmen (11) mit Seitenwänden (14, 15, 20, 21), wobei der Rahmen (11) zur Montage an einer Montagewand (24) mit Schnellbefestigungseinrichtungen in Form von federelastischen bevorzugterweise flügelartigen Laschen (12) versehen ist,
**dadurch gekennzeichnet,**
**dass** der Rahmen (11) derart um seinen Umfang durchgehend umlaufend geschlossen ausgebildet ist, dass in den Seitenwänden (14, 15, 20, 21) des Rahmens (11) keine Öffnungen vorgesehen sind, dass die Laschen (12) außenseitig an den Rahmen (11) angeformt sind, wobei die Laschen (12) nicht aus dem Wandmaterial des Rahmens (11) herausgeformt sind, und dass ein Zwischenraum (13) zwischen einer oberen Kante einer Lasche (12) und einer eine umlaufende Montagewandanlagekante bildenden Randfläche des Grundgehäuses (10) zwischen ein und vier Millimeter beträgt.

2. Filterlüfter nach Anspruch 1,
**dadurch gekennzeichnet,**
**dass** an einer Oberseite (14) und/oder einer Unterseite (15) eines quadratischen oder rechteckigen Filterlüfters (100) jeweils an einem Eckbereich (16, 17, 18, 19) eine Lasche (12) angeordnet ist.

3. Filterlüfter nach einem der Ansprüche 1 oder 2,
**dadurch gekennzeichnet,**
**dass** an einer oder mehreren Seitenwänden (14, 15, 20; 21) des Rahmens (11) jeweils eine Lasche (12), insbesondere im Wesentlichen mittig, angeordnet ist.

4. Filterlüfter nach einem der Ansprüche 1 bis 3,
**dadurch gekennzeichnet,**
**dass** mindestens an jeweils zwei sich gegenüberliegenden Seitenwänden des Rahmens (11) mindestens eine Lasche (12) vorgesehen ist.

5. Filterlüfter nach einem der Ansprüche 1 bis 4,
**dadurch gekennzeichnet,**
**dass** der Montagewandanlagekante ein Dichtungsmittel zugeordnet ist, insbesondere eine in eine Nut eingesetzte Gummidichtung (22).

6. Filterlüfter nach einem der Ansprüche 1 bis 5,
**dadurch gekennzeichnet,**
**dass** die Laschen (12) dreieckig und/oder rechteckig ausgeformt sind.

7. Anordnung umfassend mehrere Filterlüfter, die jeweils nach einem der Ansprüche 1 bis 6 ausgebildet sind,
**dadurch gekennzeichnet,**
**dass** ein Filterlüfter (100) mit Verbindungselementen mit wenigstens einem weiteren bauartgleichen Filterlüfter (100) verbindbar ist, insbesondere die Verbindungselemente mit den Laschen (12) in rastenden Eingriff bringbar sind.

## Claims

1. Filter fan (100) with a basic housing (10) comprising a frame (11) with side walls (14, 15, 20, 21), wherein the frame (11) is provided with rapid fastening devices in the form of spring-elastic, preferably wing-like clips (12) for mounting to a mounting wall (24),
**characterised in that**
the frame (11) is constructed so as to be closed all around its circumference, **in that** no openings are provided in the side walls (14, 15, 20, 21) of frame (11), **in that** the clips (12) are moulded onto the frame (11) on the outside, wherein the clips (12) are not moulded out of the wall material of the frame (11), and **in that** an in-between space (13) between an upper edge of a clip (12) and a rim surface of the basic housing (10) forming a circumferential mounting wall fitting edge amounts to between one and four millimetres.

2. Filter fan according to claim 1,
**characterised in that**
a clip (12) is provided in each corner area (16, 17, 18, 19) on a top side (14) and/or an underside (15) of a square or rectangular filter fan (100).

3. Filter fan according to one of claims 1 or 2,
**characterised in that**
a clip (12) is provided, respectively, on one or more side walls (14, 15, 20; 21) of the frame (11), in particular substantially centrally.

4. Filter fan according to one of claims 1 to 3,
**characterised in that**
at least one clip (12) is provided at least on two side walls of the frame (11) lying opposite one another.

5. Filter fan according to one of claims 1 to 4,
**characterised in that**
a sealing means, in particular a rubber seal (22) inserted into a groove, is associated with the mounting wall fitting edge.

6. Filter fan according to one of claims 1 to 5,
**characterised in that**
the clips (12) are shaped so as to be triangular and/or rectangular.

7. Arrangement comprising several filter fans which are constructed according to one of claims 1 to 6, respectively,
**characterised in that**
a filter fan (100) can be connected, via connecting elements, with at least one further filter fan (100) of identical construction, in particular the connecting elements can be brought into locking engagement with the clips (12).

## Revendications

1. Aérateur à filtre (100) comprenant un boîtier de base (10) avec un cadre (11) pourvu de parois latérales (14, 15, 20, 21), le cadre (11) étant doté, pour le montage sur une paroi de montage (24), de dispositifs à fixation rapide sous la forme de pattes (12) élastiques comme un ressort et de préférence de type ailette, **caractérisé en ce que**
le cadre (11) est conçu fermé en continu autour de sa périphérie de telle sorte qu'aucune ouverture n'est prévue dans les parois latérales (14, 15, 20, 21) du cadre (11), que les pattes (12) sont rapportées côté extérieur sur le cadre (11), les pattes (12) n'étant pas formées à partir du matériau de paroi du cadre (11), et **en ce qu'**un espace intermédiaire (13) entre une arête supérieure d'une patte (12) et une surface de bordure, formant une arête périphérique d'appui de paroi de montage, du boîtier de base (10) varie entre 1 et 4 mm.

2. Aérateur à filtre selon la revendication 1,
**caractérisé en ce que**
une patte (12) est disposée sur un côté supérieur (14) et/ou un côté inférieur (15) d'un aérateur à filtre (100) carré ou rectangulaire à chaque fois sur une zone d'angle (16, 17, 18, 19).

3. Aérateur à filtre selon l'une quelconque des revendications 1 ou 2,
**caractérisé en ce que**
à chaque fois une patte (12) est disposée sur une ou plusieurs parois latérales (14, 15, 20 ; 21) du cadre (11), en particulier sensiblement au centre.

4. Aérateur à filtre selon l'une quelconque des revendications 1 à 3,
**caractérisé en ce que**
au moins une patte (12) est prévue au moins sur respectivement deux parois latérales se faisant face du cadre (11).

5. Aérateur à filtre selon l'une quelconque des revendications 1 à 4,
**caractérisé en ce que**
un moyen d'étanchéité, en particulier un joint en caoutchouc (22) inséré dans une rainure, est attribué à l'arête d'appui de paroi de montage.

6. Aérateur à filtre selon l'une quelconque des revendications 1 à 5,
**caractérisé en ce que**
les pattes (12) sont formées sous forme de triangle et/ou de rectangle.

7. Agencement comprenant plusieurs aérateurs à filtre, qui sont conçus respectivement selon l'une quelconque des revendications 1 à 6,
**caractérisé en ce que**
un aérateur à filtre (100) peut être relié par des éléments de liaison à au moins un autre aérateur à filtre (100) de conception identique, en particulier les éléments de liaison peuvent être amenés en prise par encliquetage avec les pattes (12).
